Europäisches Patentamt

European Patent Office

Office européen des brevets

(19)

(11) Publication number: **0 195 789**
**B1**

(12) **EUROPEAN PATENT SPECIFICATION**

(45) Date of publication of patent specification: 29.11.89

(51) Int. Cl.⁴: **H 05 K 9/00**

(21) Application number: **85904611.2**

(22) Date of filing: **17.09.85**

(86) International application number:
**PCT/DK85/00089**

(87) International publication number:
**WO 86/01969 27.03.86 Gazette 86/07**

(54) **AN ELECTRONIC APPARATUS OR COMPONENT AND A METHOD OF PROVIDING SUCH AN APPARATUS OR COMPONENT.**

(30) Priority: **18.09.84 DK 4451/84**

(43) Date of publication of application:
**01.10.86 Bulletin 86/40**

(45) Publication of the grant of the patent:
**29.11.89 Bulletin 89/48**

(84) Designated Contracting States:
**AT CH DE FR GB LI NL SE**

(56) References cited:
**DE-A-3 445 161**
**DE-A-3 447 347**
**GB-A-2 101 811**
**GB-A-2 123 216**
**SE-B- 391 105**
**US-A-3 721 746**
**US-A-3 816 911**
**US-A-4 370 700**

(73) Proprietor: **STORNO A/S**
**Artillerivej 126**
**DK-2300 Copenhagen S (DK)**

(72) Inventor: **TUGCU, Mehmet**
**Rhodesiavej 6**
**DK-2770 Kastrup (DK)**

(74) Representative: **Patentanwälte Grünecker, Kinkeldey, Stockmair & Partner**
**Maximilianstrasse 58**
**D-8000 München 22 (DE)**

# Description

The present invention relates to the electronic field. More specifically, a first aspect of the present invention relates to an electronic apparatus comprising a housing having walls of an electrically conductive material and together defining an inner space of the housing.

Within the electronic industry, different kinds of electronic apparatuses of the above type are provided. Within particular fields of the electronic industry, electronic apparatus are provided in which various electronic circuits are included which require shielding from one another and from the environment or surroundings. An example of such a field is the telecommunication field. In the commonly employed shielding technique the individual electronic circuits are shielded from each other and from the environment or surroundings in individual metallic encasings. In one embodiment of this circuit encasing technique, the individual electronic circuits are provided on separate circuit boards, such as printed circuit boards, e.g. single or double-sided printed circuit boards, which are enclosed within individual metallic encasings or housings. However, as the electronic industry is moving towards a miniaturizing of the electronic circuits, involving the technique of providing integrated circuits and further involving the well-known layer techniques, including thick-film technique and thin-film technique, the provision of the individual electronic circuits to be shielded from one another and from the environment or surroundings on separate circuit boards and arranging the individual circuit boards within individual metallic encasings is considered to be an irrational technique which to a great deal counteracts the miniaturizing and integration trend.

In order to solve the problem of combining the miniaturizing and integration technique and the shielding requirements of the electronic circuits which are to be shielded, it has been attempted to arrange the electronic components together constituting the electronic circuits of the apparatus on a single circuit board and to provide shielding of individual electronic circuits in relation to one another and in relation to the environment or surroundings.

In SE—B 391105 one of these attempts is disclosed including the provision of a pair of parallelly and closely extending shielding plates having lugs inserted into apertures of a circuit board which are soldered to the circuit board together with the electronic components and which together define compartments in which the individual electronic circuits are encased. The circuit board including the electronic components and the shielding plates is arranged within the inner space of the apparatus housing which serves the purpose of shielding the electronic circuit in relation to the environment, the housing top wall having a wall suspending therefrom and being inserted into the space between said shielding wells. However, this technique is not quite satisfactory since it involves the provision of a great number of individual components, viz. the individual shielding plates, which are to be mounted and soldered onto the circuit board. Furthermore, the shielding plates have to provide galvanic contact with the apparatus housing and, consequently, contact means serving the purpose of establishing contact between the shielding plates and the apparatus housing must be provided.

A further problem relating to the technique of providing separate shielding plates soldered on to the circuit board and encasing the electronic circuits also mounted thereon originates from the trend to mount more and more components on the circuit board by arranging components on both sides thereof and soldering the components onto the circuit board in automatized processes such as dip soldering processes or wave soldering processes in which the entire circuit board having all components arranged on both sides thereof is soldered. When employing these automatized soldering processes, the above shielding plates have to be arranged on the side of the circuit board opposite to the side from which the solder is supplied as the individual compartments defined by the shielding plates would be filled out with solder in case it is attempted to supply solder to the side of the circuit board on which the shielding plates are mounted.

In another attempt to combine the miniaturizing and integration of the electronic circuits and the shielding of the individual electronic circuits described in US Patent No. 4,370,700, it has been suggested to provide a housing having integrally formed perpendicular walls extending outwardly from the housing into the inner space thereof and to arrange the printed circuit board in abutting engagement with the perpendicularly extending walls so that the circuit board is positioned parallel with the base of the housing and the perpendicularly extending walls encircle the circuits which are located on the board and which are to be shielded.

Although this well-known technique eliminates some of the major disadvantages of the above described technique involving the provision of individual shielding plates soldered on to the circuit, viz. reduces the number of components, this technique still suffers from several severe drawbacks. First of all as the shielding effect is highly dependent on the close abutting arrangement of the circuit board relative to the perpendicularly extending walls. Even a minor gap between the outer side surface of the circuit board and the perpendicularly extending wall of the housing may cause deteriorating leakage which to a great extent reduces the desired shielding effect. Furthermore, as the shielding walls are arranged on one side of the circuit board exclusively, the shielding effect is reduced as compared to the technique involving individual encasings enclosing the individual electronic circuits to be shielded.

Therefore, it is an object of the present invention to provide an apparatus of the above described type in which a single electronic circuit board including the electronic circuits is provided and in which the electronic circuits to be shielded from one another are effectively shielded from each other and from the environment or surroundings.

This object is obtained in an electronic apparatus according to the invention comprising a housing having walls of an electrically conductive material and together defining an inner space of the housing, and an electronic circuit board arranged within said inner space and including at least two electronic circuits located at different sections of the circuit board, the circuit board further being provided with at least one aperture separating said sections from each other, and the walls of the housing comprising outer walls and at least one partition wall extending from one of said outer walls into the inner space of the housing and through said at least one aperture of the circuit board, so as to substantially divide the inner space of the housing into mutually shielded compartments each containing one of said sections of the circuit board.

Although the individual electronic circuits located at different sections of the circuit board may be totally independent of each other and operate independently of each other, the teaching of the present invention renders it possible to provide said at least two circuits adapted to cooperate electronically, and to provide the electronic circuit board provided with a circuit interconnecting said sections of the circuit board, as the shielding of the electronic circuit is accomplished by the partition wall extending through the aperture of the circuit board.

The teaching of the present invention may be combined with any of the well-known circuit board techniques, including printed circuit boards, either single-sided or double-sided printed circuit boards, multi-layer printed circuit boards and layer techniques, such as thin-layer technique and thick-layer technique, involving the provision of the circuit board as a thick-film substrate.

The at least one partition wall which in accordance with the principles of the present invention extends from one of the outer walls of the housing into the inner space of the housing may be constituted by a separate wall component which is either removably or fixedly fastened to the inner surface of the said one outer wall. However, in accordance with the presently preferred embodiment of the invention, the partition wall is an integral part of the said outer wall of the housing. By providing the partition wall as an integral part, it is rendered possible to provide the said outer wall of the housing together with the partition wall or the partition walls in a single production process, such as a drawing, casting or pouring process.

Since said at least one partition wall is conventionally of a plate configuration, said at least one aperture assigned thereto may preferably be of a substantially elongated configuration or composed of segments of a substantially elongated configuration adapted to said plate configuration of the partition wall.

In accordance with the preferred embodiment of the apparatus according to the invention, the walls of the housing are of substantially rectangular configurations. In this preferred embodiment of the apparatus according to the invention, the house may be provided with generally parallel top and base walls, the circuit board may be arranged generally parallel to said top and base walls, the said one outer wall of the housing may be the base wall of the housing, and said at least one partition wall may extend generally perpendicularly from the base wall to the top wall of the housing.

Although the circuit board may obviously be mounted and fastened to any of the outer walls of the housing in any appropriate manner, e.g. by means of conventional fastening means, such as screws, bolts etc., i.e. fastened to the top, side, front or rear wall of the housing, the circuit board is preferably mounted on and fastened to the base wall of the housing, and the top wall is a removable wall providing direct access to the circuit board when removed from the housing.

Another aspect of the present invention relates to an electronic component in which the shielding technique of the present invention is employed. The electronic component according to the invention comprises a housing having walls of an electrically conductive material and together defining an inner space of the housing, and an electronic circuit board arranged within said inner space and including at least two electric circuits located at different sections of the circuit board, the circuit board further being provided with at least one aperture separating said sections from each other, and the walls of the housing comprising outer walls and at least one partition wall extending from one of said outer walls of the housing into the inner space of the housing and through said at least one aperture of the circuit board, so as to substantially divide the inner space of the housing into mutually shielded compartments each containing one of said sections of the circuit board. The electronic component according to the invention may be of any configuration, e.g. included in any of the conventional electronic component packages or may constitute a subcomponent or subapparatus of a main apparatus.

The electronic component according to the invention may further include any of the above described characteristics of the apparatus according to the invention and may further have the inner space of the housing filled with an electrically insulating casting as is conventional in the art and serving the well-known mechanical fixation, insulation and impenetration purposes.

A further aspect of the present invention relates to a method providing an electronic apparatus or an electronic component including at least two electronic circuits, comprising:

providing a housing having walls of an electrically conductive material and together defining an inner space of the housing, at least a part of one of the walls of the housing being removable so as to provide an opening to the inner space of the housing, and the walls of the housing comprising outer walls and at least one partition wall extending from one of the outer walls of the housing into the inner space of the housing substantially dividing the inner space of the housing into at least two compartments,

providing an electronic circuit board having at least one aperture and including said at least two electronic circuits located at different sections of the circuit board, said at least one aperture separating said sections from each other,

introducing the circuit board into the inner space of the housing through the opening thereto,

arranging the circuit board in the inner space of the housing so as to make said at least one partition wall of the housing extend through said at least one aperture of the circuit board in order to arrange said sections of the circuit board in said compartments of the inner space of the housing so as to mutually shield said compartments and said sections arranged therein from each other, and

arranging said at least part of one wall of the housing thereon so as to shield said sections of the circuit board from the environment or the surroundings.

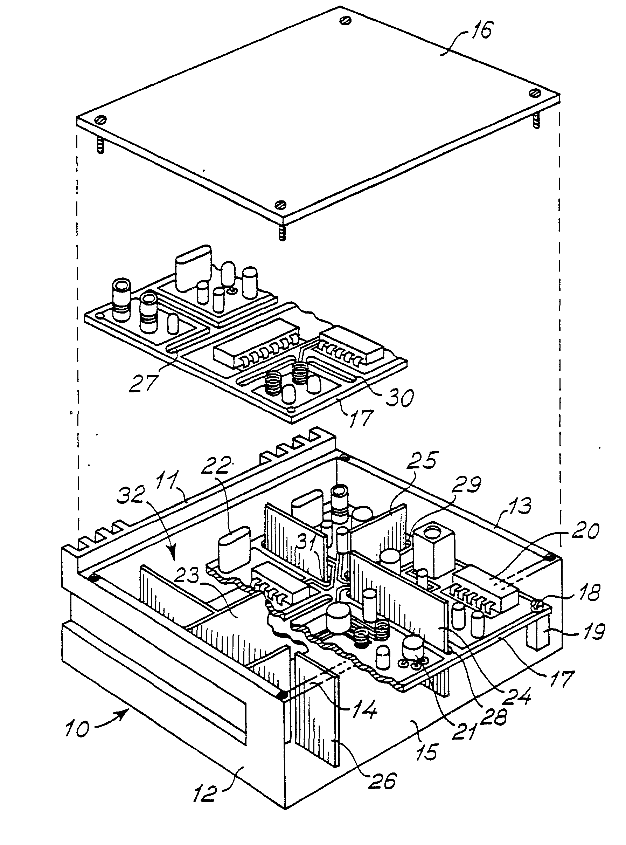

The invention will now be further described with reference to the drawing, on which a perspective, partially cut-away view of a preferred embodiment of an apparatus according to the invention is shown.

In the drawing, an apparatus housing designated 10 in its entirety is shown. The housing 10 comprises a rear wall 11 which further constitutes a heat sink of the apparatus and is provided with protruding heat radiating fins, side walls 12 and 13, a front wall 14 which is partially shown in dotted line, a base wall 15, and a detachable cover 16 constituting the top wall of the housing. The outer walls 11—16 of the apparatus housing 10 defines an inner space 32 of the housing. Within the inner space 32, a printed circuit board 17 is arranged. As is evident from the drawing, the printed circuit board 17 is fastened to the base wall 15 of the apparatus housing by means of screws, one of which is shown on the drawing and designated the reference numeral 18, and distance pieces, one of which is shown on the drawing and designated the reference numeral 19.

On the upper side surface of the printed circuit board 17 electronic components, including an integrated circuit designated 20, a transistor designated 21, and a capacitor 22, are arranged and soldered on to circuit tracks of the printed circuit board. Apart from the electronic components arranged on the upper side surface of the printed circuit board 17, the printed circuit board may in accordance with the teaching of the present invention further be provided with electronic components arranged on the lower side surface of the printed circuit board.

As will be understood, the apparatus housing 10 shields the electronic circuits of the electronic apparatus from the environments or the surroundings. However, the individual circuits of the apparatus which are located at different sections of the printed circuit board 17, may further require shielding from each other. This shielding of the individual electronic circuits from each other is in accordance with the principles of the present invention provided by means of partition walls, four of which are designated the reference numerals 23—26, and which extend generally perpendicularly from the base wall 15 of the apparatus housing 10 into the inner space 32 thereof. As is evident from the drawing, the partition walls 23—26 extend to such a height that the upper edges of the partition walls are brought into contact with the lower side surface of the detachable cover 16 when the cover is mounted on top of the apparatus housing. The circuit board 17 is provided with apertures through which the partition walls extend and four of which are designated the refrence numerals 27—30. As is evident from the drawing, the apertures are basically of an elongated configuration and further provide areas of the circuit board interconnecting the individual sections thereof first of all serving the purpose of mechanically keeping the entire circuit board together and further serving the purpose of providing electrical connection between the individual sections of the circuit board as illustrated by a circuit track 31.

## Claims

1. An electronic apparatus comprising a housing (10) having walls (11—16, 23—26) of an electrically conductive material and together defining an inner space (32) of the housing (10), and an electronic circuit board (17) arranged within said inner space (32) and including at least two electronic circuits (20, 21, 22) located at different sections of the circuit board (17), the circuit board (17) further being provided with at least one aperture (27—30) separating said sections from each other, and the walls (11—16, 23—26) of the housing (10) comprising outer walls (11—16) and at least one partition wall (23—26) extending from one (15) of said outer walls (11—16) into the inner space (32) of the housing (10), and through said at least one aperture (27—30) of the circuit board (17), so as to substantially divide the inner space (32) of the housing (10) into mutually shielded compartments each containing one of said sections of the circuit board (17).

2. An apparatus according to claim 1, said at least two circuits (20, 21, 22) being adapted to electronically cooperate, and the electronic circuit board (17) being provided with a circuit (31) interconnecting said sections of the circuit board.

3. An apparatus according to claim 1 or 2, the circuit board (17) being a printed circuit board.

4. An apparatus according to claim 3, the printed circuit board (17) being a double-sided printed circuit board.

5. An apparatus according to claim 3, the printed circuit board (17) being a multi-layer printed circuit board.

6. An apparatus according to claim 1 or 2, the circuit board (17) being a thick-film substrate.

7. An apparatus according to any of the preceding claims, the partition wall (23—26) being an integral part of the said outer wall (15) of the housing (10).

8. An apparatus according to any of the preceding claims, said at least one aperture (23—26) being of a substantially elongated configuration or composed of segments of substantially elongated configurations.

9. An apparatus according to any of the preceding claims, the walls (11—16, 23—26) of the housing (10) being of substantially rectangular configurations.

10. An apparatus according to claim 9, the housing (10) being provided with generally parallel top and base walls (15, 16), the circuit board (17) being arranged generally parallel to said top and base walls (15, 16), the said one outer wall of the housing being the base wall (15) of the housing (10), and said at least one partition wall (23—26) extending generally perpendicularly from the base wall (15) to the top wall (16) of the housing (10).

11. An apparatus according to claim 10, the circuit board (17) being mounted on and fastened to the base wall (15) of the housing (10), and the top wall (16) being removable.

12. An electronic component comprising a housing (10) having walls (11—16, 23—26) of an electrically conductive material and together defining an inner space (32) of the housing (10), and an electronic circuit board (17) arranged within said inner space (32) and including at least two electric circuits (20, 21, 22) located at different sections of the circuit board (17), the circuit board (17) further being provided with at least one aperture (23—26) separating said sections from each other, and the walls (11—16, 23—26) of the housing (10) comprising outer walls (11—16) and at least one partition wall (23—26) extending from one (15) of said outer walls (11—16) of the housing (10) into the inner space (32) of the housing (10) and through said at least one aperture (27—30) of the circuit board (17), so as to substantially divide the inner space (32) of the housing (10) into mutually shielded compartments each containing one of said sections of the circuit board (17).

13. An electronic component according to claim 12, said at least two circuits (20, 21, 22) being adapted to electronically cooperate, and the electronic circuit board (17) being provided with a circuit (31) interconnecting said sections of the circuit board (17).

14. An electronic component according to claim 12 or 13, the circuit board (17) being a thick-film substrate.

15. An electronic component according to any of the claims 12—14, the partition wall (23—26) being an integral part of the said outer wall of the housing (10).

16. An electronic component according to any of the claims 12—15, the inner space (32) of the housing (10) being filled with an electrically insulating casting.

17. A method of providing an electronic apparatus or an electronic component including at least two electronic circuits, comprising:

providing a housing having walls of an electrically conductive material and together defining an inner space of the housing, at least a part of one of the walls of the housing being removable so as to provide an opening to the inner space of the housing, and the walls of the housing comprising outer walls and at least one partition wall extending from one of the outer walls of the housing into the inner space of the housing substantially dividing the inner space of the housing into at least two compartments,

providing an electronic circuit board having at least one aperture and including said at least two electronic circuits located at different sections of the circuit board, said at least one aperture separating said sections from each other,

introducing the circuit board into the inner space of the housing through the opening thereto,

arranging the circuit board in the inner space of the housing so as to make said at least one partition wall of the housing extend through said at least one aperture of the circuit board in order to arrange said sections of the circuit board in said compartments of the inner space of the housing so as to mutually shield said compartments and said sections arranged therein from each other, and

arranging said at least part of one wall of the housing thereon so as to shield said sections of the circuit board from the environment or the surroundings.

**Patentansprüche**

1. Elektronisches Gerät, umfassend ein Gehäuse (10) mit Wänden (11—16, 23—26) aus einem elektrisch leitfähigen Material, die zusammen einen Innenraum (32) des Gehäuses (10) umschließen, und eine elektronsiche Schaltungskarte (17), die in dem Innenraum (32) angeordnet ist und wenigstens zwei elektronische Schaltungen (20, 21, 22) enthält, die an unterschiedlichen Sektionen der Schaltungskarte (17) angeordnet sind, wobei die Schaltungskarte (17) weiterhin mit wenigstens einer Öffnung (27—30) versehen ist, die die genannten Sektionen voneinander trennt, und die Wände (11—16, 23—26) des Gehäuses (10) Außenwände (11—16) und wengistens eine Trennwand (23—26) umfassen, die sich von einer (15) der Außenwände (11—16) in den Innenraum (32) des Gehäuses (10) und durch die genannte wenigstens eine Öffnung (27—30) der Schaltungskarte (17) erstreckt, um den Innenraum (32) des Gehäuses (10) in voneinander abgeschirmte Abteile im wesentlichen zu unterteilen, die jeweils eine der genannten Sektionen der Schaltungskarte (17) enthalten.

2. Gerät nach Anspruch 1, wobei die genannten wenigstens zwei Schaltungen (20, 21, 22) dazu eingerichtet sind, elektronisch zusammenzuwirken, und die elektronische Schaltungskarte (17) mit einer Schaltung (31) versehen ist, die die genannten Sektionen der Schaltungskarte miteinander verbindet.

3. Gerät nach Anspruch 1 oder 2, wobei die Schaltungskarte (17) eine Druckschaltungskarte ist.

4. Gerät nach Anspruch 3, bei dem die Druckschaltungskarte (17) eine doppelseitig bedruckte Schaltungskarte ist.

5. Gerät nach Anspruch 3, bei dem die Druckschaltungskarte (17) eine Mehrschichtdruckschaltungskarte ist.

6. Gerät nach Anspruch 1 oder 2, bei dem die Druckschaltungskarte (17) ein Dickfilmsubstrat ist.

7. Gerät nach einem der vorhergehenden Ansprüche, bei dem die Trennwand (23—26) ein integraler Teil der genannten Außenwand (15) des Gehäuses (10) ist.

8. Gerät nach einem der vorhergehenden Ansprüche, bei dem die genannte wengistens eine Öffnung (23—26) von im wesentlichen länglicher Gestalt ist oder aus Segmenten im wesentlichen länglicher Gestalten zusammengesetzt ist.

9. Gerät nach einem der vorhergehenden Ansprüche, bei dem die Wände (11—16, 23—26) des Gehäuses (10) im wesentlichen rechteckige Gestalt haben.

10. Gerät nach Anspruch 9, bei dem das Gehäuse (10) mit im wesentlichen parallelen Ober- und Unterwänden (15, 16) versehen ist, die Schaltungskarte (17) im wesentlichen parallel zu den gennanten Ober- und Unterwänden (15, 16) angeordnet ist, die genannte eine Außenwand des Gehäuses die Unterwand (15) des Gehäuses (10) ist und die genannte wenigstens eine Trennwand (23—26) sich im wesentlichen senkrecht von der Unterwand (15) zur Oberwand (16) des Gehäuses (10) erstreckt.

11. Gerät nach Anspruch 10, bei dem die Schaltungskarte (17) an der Unterwand (15) des Gehäuses (10) montiert und befestigt ist und die Oberwand (16) lösbar ist.

12. Elektronische Baugruppe, umfassend ein Gehäuse (10) mit Wänden (11—16, 23—26) aus einem elektrisch leitfähigen Material, die zusammen einen Innenraum (32) des Gehäuses (10) umschließen, und eine elektronische Schaltungskarte (17), die in dem gennanten Innenraum (32) angeordnet ist und wenigstens zwei elektrische Schaltungen (20, 21, 22) enthält, die an unterschiedlichen Sektionen der Schaltungskarte (17) angeordnet sind, wobei die Schaltungs karte (17) weiterhin mit wenigstens einer Öffnung (27—30) versehen ist, die die genannten Sektionen voneinander trennt, und die Wände (11—16, 23—26) des Gehäuses (10) Außenwände (11—16) und wenigstens eine Trennwand (23—26) umfassen, die sich von einer (15) der genannten Außenwände (11—16) des Gehäuses (10) in den Innenraum (32) des Gehäuses (10) und durch die genannte wenigstens eine Öffnung (23—26) der Schaltungskarte (17) hindurch erstreckt, um den Innenraum (32) des Gehäuses (10) in voneinander abgeschirmte Abteile im wesentlichen zu unterteilen, die jeweils eine der Sektionen der Schaltkarte (17) enthalten.

13. Elektronische Baugruppe nach Anspruch 12, wobei die genannten wenigstens zwei Schaltungen (20, 21, 22) dazu eingerichtet sind, elektronisch zusammenzuwirken, und die elektronische Schaltungskarte (17) mit einer Schaltung (31) versehen ist, die die genannte Sektionen der Schaltungskarte (17) miteinander verbindet.

14. Elektronische Baugruppe nach Anspruch 12 oder 13, wobei die Schaltungskarte (17) ein Dickfilmsubstrat ist.

15. Elektronische Baugruppe nach einem der Ansprüche 12 bis 14, bei der die Trennwand (23—26) ein integraler Teil der genannten Außenwand des Gehäuses (10) ist.

16. Elektronische Baugruppe nach einem der Ansprüche 12 bis 15, bei der der Innenraum (32) des Gehäuses (10) mit einer elektrisch isolierenden Vergußmasse gefüllt ist.

17. Verfahren zum Erstellen eines elektronischen Gerätes oder einer elektronischen Baugruppe mit wenigstens zwei elektronischen Schaltungen, umfassend:

Bereitstellen eines Gehäuses, das Wände aus einem elektrisch leitfähigen Material enthält, die zusammen einen Innenraum des Gehäuses umschließen, wobei wenigstens ein Teil von einer der Wände des Gehäuses lösbar ist, um eine Öffnung zum Innenraum des Gehäuses auszubilden, und die Wände des Gehäuses Außenwände und wenigstens eine Trennwand umfassen, die sich von einer der Außenwände des Gehäuses in den Innenraum des Gehäuses erstreckt, den Innenraum des Gehäuses in wenigstens zwei Abteile im wesentlichen unterteilend,

Bereitstellen einer elektronischen Schaltungskarte, die wenigstens eine Öffnung hat und die wenigstens zwei elektronische Schaltungen enthält, die an unterschiedlichen Sektionen der Schaltungskarte angeordnet sind, wobei die genannte wenigstens eine Öffnung die genannten Sektionen voneinander trennt,

Einführen der Schaltungskarte in den Innenraum des Gehäuses durch dessen Öffnung,

Anordnen der Schaltungskarte im Innenraum des Gehäuses derart, daß die genannte wenigstens eine Trennwand des Gehäuses sich durch die gennante wenigstens eine Öffnung der Schaltungskarte hindurch erstreckt, um die genannten Sektionen der Schaltungskarte in den Abteilen des Innenraumes des Gehäuses anzuordnen, um die genannten Abteile und die genannten, darin angeordneten Sektionen gegenseitig voneinander abzuschirmen, und

Anordnen des genannten wenigstens Teils einer Wand des Gehäuses darauf, um die genannten Sektionen der Schaltungskarte gegenüber der Umgebung abzuschirmen.

## Revendications

1. Un appareil électronique, comportant un boîtier (10), comprenant des parois (11 à 16, 23 à 26) en matériau électriquement conducteur qui définissent ensemble un volume intérieur (32) du boîtier (10), et une plaque de circuit électronique (17) placée dans ce volume intérieur (32) et comprenant au moins deux circuits électroniques (20, 21, 22) situés en différentes régions de la plaque de circuit (17), la plaque de circuit (17) étant également pourvue d'au moins une ouverture (27 à 30) séparant entre elles ces régions, et les parois (11 à 16, 23 à 26) du boîtier (10) comprenant des parois extérieures (11 à 16) et au moins une paroi de séparation (23 à 26) s'étendant depuis l'une (15) de ces parois extérieures (11 à 16) dans le volume intérieur (32) du boîtier (10) en traversant l'ouverture ou les ouvertures (27 à 30) de la plaque de circuit (17), de manière à essentiellement diviser le volume intérieur (32) du boîtier (10) en compartiments mutuellement blindés enfermant chacun l'une desdites régions de la plaque de circuit (17).

2. L'appareil de la revendication 1, dans lequel lesdits deux circuits au moins (20, 21, 22) sont conçus de manière à coopérer électroniquement, et dans lequel la plaque de circuit électronique (17) est pourvue d'un circuit (31) interconnectant lesdites régions de la plaque de circuit.

3. L'appareil de l'une des revendications 1 et 2, dans lequel la plaque de circuit (17) est une plaque de circuit imprimé.

4. L'appareil de la revendication 3, dans lequel la plaque de circuit imprimé (17) est une plaque de circuit imprimé double face.

5. L'appareil de la revendication 3, dans lequel la plaque de circuit imprimé (17) est une plaque de circuit imprimé multicouche.

6. L'appareil de l'une des revendications 1 et 2, dans lequel la plaque de circuit (17) est un substrat en film épais.

7. L'appareil de l'une des revendications précédentes, dans lequel la paroi de séparation (23 à 26) est monobloc avec la paroi extérieure (15) du boîtier (10).

8. L'appareil de l'une des revendications précédentes, dans lequel l'ouverture ou les ouvertures (23 à 26) sont de configuration essentiellement allongée ou sont composées de segments de configuration essentiellement allongée.

9. L'appareil de l'une des revendications précédentes, dans lequel les parois (11 à 16, 23 à 26) du boîtier (10) sont de configuration essentiellement rectangulaire.

10. L'appareil de la revendication 9, dans lequel le boîtier (10) est pourvu de parois supérieur (16) et de base (15) généralement parallèles, la plaque de circuit (17) est disposée de façon généralement parallèle à ces parois supérieure (16) et de base (15), ladite paroi extérieure du boîtier est la paroi de base (15) du boîtier (10), et la paroi ou les parois de séparation (23 à 26) s'étendent généralement à angle droit par rapport à la paroi de base (15) et depuis celle-ci jusqu'à la paroi supérieure (16) du boîtier (10).

11. L'appareil de la revendication 10, dans lequel la plaque de circuit (17) est montée sur la paroi de base (15) du boîtier (10) et fixée à celle-ci, et dans lequel la paroi supérieure (16) est amovible.

12. Un composant électronique, comportant un boîtier (10), comprenant des parois (11 à 16, 23 à 26) en matériau électriquement conducteur qui définissent ensemble un volume intérieur (32) du boîtier (10), et une plaque de circuit électronique (17) placée dans ce volume intérieur (32) et comprenant au moins deux circuits électroniques (20, 21, 22) situées en différentes régions de la plaque de circuit (17), la plaque de circuit (17) étant également pourvue d'au moins une ouverture (27 à 30) séparant entre elles ces régions, et les parois (11 à 16, 23 à 26) du boîtier (10) comprenant des parois extérieures (11 à 16) et au moins une paroi de séparation (23 à 26) s'étendant depuis l'une (15) de ces parois extérieures (11 à 16) dans le volume intérieur (32) du boîtier (10) en traversant l'ouverture ou les ouvertures (27 à 30) de la plaque de circuit (17), de manière à essentiellement diviser le volume intérieur (32) du boîtier (10) en compartiments mutuellement blindés enfermant chacun l'une desdites régions de la plaque de circuit (17).

13. Le composant électronique de la revendication 12, dans lequel lesdits deux circuits au moins (20, 21, 22) sont conçus de manière à coppérer électroniquement, et dans lequel la plaque de circuit électronique (17) est pourvue d'un circuit (31) interconnectant lesdites régions de la plaque de circuit.

14. Le composant électronique de l'une des revendications 12 et 13, dans lequel la plaque de circuit (17) est un substrat en film épais.

15. Le composant électronique de l'une des revendications 12 à 14, dans lequel la paroi de séparation (23 à 26) est monobloc avec la paroi extérieur (15) du boîtier (10).

16. Le composant électronique de l'une des revendications 12 à 15, dans lequel le volume intérieur (32) du boîtier (10) est rempli d'un garnissage électriquement isolant.

17. Un procédé de réalisation d'un appareil électronique ou d'un composant électronique comprenant au moins deux circuits électroniques, comprenant les étapes consistant à:

constituer un boîtier comprenant des parois en matériau électriquement conducteur qui définissent ensemble un volume intérieur du boîtier, au moins une partie de l'une des parois du boîtier étant amovible afin de procurer un accès au volume intérieur du boîtier, et les parois du boîtier comprenant des parois extérieures et au moins une paroi de séparation s'étendant depuis l'une de ces parois extérieures dans le volume intérieur du boîtier de manière à essentiellement diviser le volume intérieur du boîtier en au moins deux compartiments, constituer une plaque de circuit électronique comprenant au moins une ouverture et comprenant lesdits deux circuits électroniques au moins, circuits qui sont situés en différentes régions de la plaque de circuit, ladite ouverture ou lesdites ouvertures séparant entre elles ces régions,

introduire la plaque de circuit dans le volume intérieur du boîtier par ledit accès à celui-ci,

disposer la plaque de circuit dans le volume intérieur du boîtier de telle sorte que la paroi ou les parois de séparation du boîtier traversent l'ouverture ou les ouvertures de la plaque de circuit, de manière à placer lesdites régions de la plaque de circuit dans lesdits compartiments du volume intérieur du boîtier afin d'isoler mutuellement ces compartiments et lesdites régions qui s'y trouvent, et

placer ladite partie au moins de l'une des parois du boîtier sur ce dernier afin de blinder lesdites régions de la plaque de circuit à l'égard de l'environnement ou de l'ambiance.